# EUROPÄISCHE PATENTANMELDUNG

(11) **EP 0 905 104 A1**
(43) Veröffentlichungstag der Anmeldung: **31.03.1999**
(21) Anmeldenummer: 98117051.7
(22) Anmeldetag: 09.09.1998
(51) Int. Cl.: C04B 35/45, C04B 35/64, H01L 39/24

(54) **Verfahren zur Herstellung von hochtemperatursupraleitenden Bi (Pb) SrCaCuO-haltigen Pulvern und deren Verwendung**

(30) Priorität: 25.09.1997 DE 19742304
(71) Anmelder: Aventis Research & Technologies GmbH & Co. KG, 65926 Frankfurt am Main (DE)
(72) Erfinder: Lang, Christoph, Dr., 65929 Frankfurt (DE); Neubacher, Marc, Dr., 60529 Frankfurt (DE); Riedel, Günter, Dr., 65779 Kelkheim (DE)

(57) **Zusammenfassung**

Die Erfindung betrifft ein Verfahren zur Herstellung von hochtemperatursupraleitenden Bi(Pb)SrCaCuO-haltigen Pulvern, bei dem eine Pulvermischung, die Verbindungen des Bi, Sr, Ca, Cu sowie wahlweise Pb enthält, die sich beim Calcinieren in die jeweiligen Oxide und/oder Mischoxide umwandeln, in einem kontinuierlichen Drehrohrofen kontinuierlich calciniert wird. Die so hergestellten Pulver können als Vorprodukt für die Herstellung von hochtemperatursupraleitenden Drähten, Bändern, Stäben, Rohren, Hohl- und Vollkörpern verwendet werden.

## Beschreibung

Die Erfindung betrifft ein Verfahren zur Herstellung von hochtemperatursupraleitenden Bi(Pb)SrCaCu0-haltigen Pulvern und deren Verwendung. Diese Pulver sind insbesondere geeignet, nach der Pulver-im-Rohr-Methode zu hochstromtragenden Bandleitern für elektrotechnische Anwendungen weiterverarbeitet zu werden. Ferner sind die Pulver geeignet, durch Preßverfahren und thermische Behandlungsschritte zu massiven hochtemperatursupraleitenden Bauteilen, wie zum Beispiel Stromzuführungen, weiterverarbeitet zu werden.

Bei der klassischen Festkörpersynthese geht man von Oxidpulvern aus, die in Wasser suspendiert, getrocknet, gemahlen und gebrannt werden. Mit diesem Verfahren ist es schwierig, Pulvermischungen mit Maximalteilchengrößen im Bereich von 5 µm durch die Mahlschritte in homogener Mischung zu erhalten. Voraussetzung für die Herstellung hochstromtragender Bandleiter ist jedoch die Verwendung eines homogenen Pulvergemischs mit kleinen Teilchengrößen.

Q. Li et al., Physica C 217 (1993) 360 - 366, referieren unter anderem über den Einfluß der mittleren Teilchengröße auf die kritische Stromdichte J_{c}, die mit abnehmender Teilchengröße zunimmt. Zur Herstellung von BiPbSrCaCuO-Pulvern gehen die Autoren von Nitratlösungen aus, die einem Sprühtrocknungs- oder einem Sprühpyrolyseverfahren unterworfen werden mit anschließenden verschiedenen thermischen Behandlungen und Mahlschritten.

Außer der geringen Teilchengröße muß das Pulver zur Herstellung von hochtemperatursupraleitenden Bändern und Bauteilen eine hohe Reinheit haben. Die Pulver sollen möglichst keine flüchtigen Fremdbestandteile enthalten. Insbesondere der Kohlenstoffgehalt soll möglichst gering sein. Darauf wird von Y. Amati et al., Physica C 185-189 (1991) 2483 - 2485, hingewiesen. Zur Herstellung von BiPbSrCaCuO-Pulvern werden von diesen Autoren Copräzipitatpulver von Oxalaten oder im festen Zustand umgesetzte Pulver von Carbonaten und Oxiden verwendet, die calciniert werden.

Auch E. E. Hellstrom et al., Supercond. Sci. Technol. 8 (1995) 317 - 323, weisen auf den störenden Einfluß des Kohlenstoffgehalts hin. Zur Herstellung von BiSrCaCuO-Pulvern wird von diesen Autoren eine Aerosol-Sprühpyrolyse angewandt, und die erhaltenen Pulvern werden anschließend bei 800 °C im Sauerstoffstrom erhitzt, um Wasser zu entfernen und den Kohlenstoffgehalt im Pulver herabzusetzen.

Die konventionelle Calcination erfolgt diskontinuierlich in einem Kammer- oder Rohrofen. Meist geht man von einer getrockneten homogenen Mischung eines Oxalatpulvers aus, das durch Copräzipitation mit anschließender Sprühtrocknung erhalten wird. Diese Mischung wird in offenen Behältern im Kammer- bzw. Rohrofen im Chargenbetrieb dreimal thermisch behandelt mit dazwischengeschalteten Siebungen. Das Verfahren ist somit arbeits- und zeitaufwendig und nicht zur Herstellung der Pulver in größeren Mengen geeignet. Außerdem findet bei der langen Dauer der thermischen Behandlung ein partielles Sintern statt, was zu einem Kornwachstum führt. Die Reinheit des Pulvers wird somit mit einer Vergrößerung der Teilchen erkauft. Für alle bekannten Verfahren zur Pulverherstellung, bei denen eine thermische Zersetzung flüchtiger Komponenten notwendig ist, gilt, daß hohe Reinheit und kleine Teilchengröße des Pulvers einander widersprechende Eigenschaften sind.

Suhas D. Schelukar et al., Ind. Eng. Chem. Res. 1994, **33,** 421 - 427, beschreiben eine kontinuierliche Calcination im Drehrohrofen zur Herstellung von hochtemperatursupraleitenden YBaCuO-Pulvern. Bei diesem Verfahren wird dem Drehrohrofen ein sprühgeröstetes Pulver zugeführt, das aus Y₂0₃, CuO und BaCO₃ besteht. Bei diesem Verfahren wird somit ein bereits thermisch vorzersetztes Ausgangsmaterial dem Drehrohrofen zugeführt, das nur eine zum Oxid zu zersetzende Komponente enthält, so daß nur kleine Volumenanteile im Ofen thermisch umgesetzt werden müssen. Es handelt sich außerdem nur um ein Dreistoffsystem. Ferner wird auf Schwierigkeiten hingewiesen, die durch Ablagerungen an der Rohrwandung entstehen. Daher müssen Schaber zur mechanischen Entfernung der Ablagerungen eingesetzt werden, um einen ungestörten Stofftransport durch den Drehrohrofen zu ermöglichen. Die Eigenschaften des so hergestellten Pulvers sind vergleichbar mit denen von konventionell hergestellten Pulvern und weisen keine Verbesserung auf.

Der vorliegenden Erfindung liegt die Aufgabe zugrunde, ein Verfahren zur Herstellung von hochtemperatursupraleitenden Bi(Pb)SrCaCu0-haltigen Pulvern zu schaffen, mit dem auf einfache Weise größere Mengen dieser Pulver in großer Reinheit und mit kleinen Teilchengrößen erhalten werden können.

Zur Lösung dieser Aufgabe wird ein Verfahren zur Herstellung von hochtemperatursupraleitenden Bi(Pb)SrCaCuO-haltigen Pulvern vorgeschlagen, das dadurch gekennzeichnet ist, daß eine Pulvermischung, die Verbindungen des Bi, Sr, Ca, Cu sowie wahlweise des Pb enthält, die sich beim Calcinieren in die Oxide und/oder Mischoxide umwandeln, in einem Drehrohrofen kontinuierlich calciniert wird.

Diese so hergestellten Pulver können als Vorprodukt für die Herstellung von hochtemperatursupraleitenden Drähten, Bändern, Stäben, Rohren, Hohl- und Vollkörpern, insbesondere zur Herstellung von Starkstromkabeln, Transformatoren, Wicklungen, Magneten oder Stromzuführungen verwendet werden.

Überraschenderweise wurde festgestellt, daß sich auch ein Vierstoff- oder ein Fünfstoffsystem, das keine thermisch vorzersetzten Bestandteile (Oxide) enthält, problemlos im Drehrohrofen kontinuierlich zu Pulvern calcinieren läßt, dessen Eigenschaften deutlich besser sind, verglichen mit den Eigenschaften von Pulvern, die nach einem konventionellen Calcinationsverfahren hergestellt werden. Die erfindungsgemäß hergestellten Pulver weisen insbesondere eine verbesserte Homogenität auf, haben eine geringe Teilchengröße und sehr niedrige Kohlenstoff- und Stickstoffgehalte. Damit erfüllen diese Pulver die Voraussetzung, daß bei ihrer Weiterverarbeitung zu Drähten gemäß der Pulver-im-Rohr-Methode oder zu massiven Bauteilen die hergestellten Endprodukte hohe Stromdichten aufweisen.

Mit dem erfindungsgemäßen Verfahren ist es möglich, Pulver herzustellen mit Maximalgrößen der Teilchen unter 3,0 µm bei mittleren Korngrößen unter 1 µm, so daß von einem Submikrometer-Pulver gesprochen werden kann. Unabhängig vom Anfangsgehalt an C und N sind die Restgehalte an C und N beim Produkt des erfindungsgemäßen Verfahrens sehr niedrig. Der C-Restgehalt liegt nicht über 1000 ppm, meist wesentlich darunter. Zum Beispiel beträgt der Anfangsgehalt an C eines Oxalats auf Basis der Zielzusammensetzung (Bi,Pb)₂Sr₂Ca₂Cu₃Oᵥ ca. 8,5 Gew.-%. Durch das erfindungsgemäße Verfahren wird dieser C-Gehalt um mindestens den Faktor 85 erniedrigt. Diese Ergebnisse sind möglich, obwohl die Verweilzeit des Materials bei hohen Temperaturen wesentlich niedriger ist als bei konventionellen Calcinierungsverfahren.

Als Ausgangsmaterial für das erfindungsgemäße Verfahren wird insbesondere eine Pulvermischung verwendet, die die Verbindungen von Bi, Sr, Ca, Cu und wahlweise von Pb oder/und gegebenenfalls weiteren Elementen in solchen Mengenverhältnissen enthält, daß die Mischung zu einem Keramikpulver der Zusammensetzung Bi_{a-y}Pb_{y}(Sr,Ca)_{b+n}Cu_{c+n}0ₓ calciniert wird, wobei
a = 1,7 bis 2,4
y = 0 bis 0,5
b = 1,6 bis 3,0
c = 1,8 bis 2,2
n = 1,2 und
x = 5,95 bis 11,5
beträgt. Vorzugsweise beträgt der Pb-Gehalt y bei Pb-haltigen Materialien 0,15 bis 0,45. Bei den Pb-freien Materialien, bei denen kein Pb zugegeben wurde, liegt der Pb-Gehalt nur in Spuren vor.

Das erfindungsgemäß im Drehrohrofen calcinierte Material weist bei der Messung von supraleitenden Eigenschaften üblicherweise bereits Spuren oder einen sehr geringen bis mittleren Gehalt an hochtemperatursupraleitenden Phasen, insbesondere an Phase Bi-2212, auf, was beispielsweise anhand der Sprungtemperatur nachweisbar ist.

Wenn das erfindungsgemäß hergestellte Pulver mit dem Pulver-im-Rohr-Verfahren zu Bändern und Drähten weiterverarbeitet werden soll, wird als Ausgangsmaterial beim erfindungsgemäßen Verfahren vorzugsweise eine Zusammensetzung der Mischung gewählt, die beim Calcinieren zur Primärphase mit der Nominalzusammensetzung (Bi,Pb)₂Sr₂Ca₁Cu₂O_{y} (Bi-2212) und Sekundärphasen in Form von CuO sowie Ca- und Sr-Cupraten bzw. -Plumbaten führt. Dieses Primär- und Sekundärphasen enthaltende Pulver ist, ggbfs. nach mindestens einer Mahlung oder/und mindestens einer Glühung zum Erzeugen eines noch höheren Anteils an hochtemperatursupraleitenden Phasen, das Endprodukt des vorliegenden Verfahrens und kann dann mit dem Pulver-im-Rohr-Verfahren zu Bändern und Drähten mit der Phase mit der Nominalzusammensetzung (Bi,Pb)₂Sr₂Ca₂Cu₃Oₓ (Bi-2223) weiterverarbeitet werden. Somit wird bei der erfindungsgemäßen Herstellung von Pulvern, die zu Bändern und Drähten weiterverarbeitet werden, als Ausgangsmaterial eine Zusammensetzung gewählt, die zur Zielzusammensetzung Bi-2223 der Bänder und Drähte führt. Die Zusammensetzung dieser Phasen kann dabei von der Nominalzusammensetzung abweichen.

Wenn das erfindungsgemäß hergestellte Pulver zur Herstellung von Massivteilen durch Pressen und thermische Behandlung verwendet werden soll, wird als Ausgangsmaterial beim erfindungsgemäßen Verfahren vorzugsweise entweder eine Zusammensetzung der Mischung gewählt, die beim Calcinieren zu dem oben genannten Produkt aus Primär- und Sekundärphasen führt, das bei der Weiterverarbeitung Bi-2223 (Zielzusammensetzung der Massivteile) ergibt, oder eine Zusammensetzung der Mischung gewählt, die beim Calcinieren zu Pulver mit der Phase Bi-2212 führt, d.h. zur Zielzusammensetzung Bi-2212 der Massivteile. Gegebenenfalls wird noch mindestens eine Mahlung oder/und mindestens eine Glühung zum Erzeugen eines noch höheren Anteils an hochtemperatursupraleitenden Phasen vor oder/und nach der Formgebung zu Formkörpern ausgeführt. Die Zusammensetzung dieser Phasen kann dabei von der Nominalzusammensetzung abweichen. In diesem Fall enthält die Pulvermischung die Verbindungen des Bi, Sr, Ca und Cu insbesondere in solchen Mengenverhältnissen, daß die Mischung zu einem Pulver der Zusammensetzung Bi_{d}SrₑCa_{f}Cu_{g}O_{z} calciniert wird, wobei
d = 1,6 bis 2,3
e = 1,7 bis 2,4
f = 0,7 bis 1,2
g = 1,7 bis 2,3 und
z = 8,0 bis 10,0
beträgt.

Die als Ausgangsmaterial verwendete Mischung kann ferner mindestens eine Verbindung eines weiteren Erdalkalimetalls, vorzugsweise Mg und/oder Ba, und/oder eine Verbindung des Hf und/oder Zr enthalten, die sich beim Calcinieren in das Oxid umwandelt bzw. in die Oxide umwandeln. Alternativ kann der Mischung mindestens ein Oxid eines weiteren Erdalkalimetalls und/oder HfO₂ und/oder ZrO₂ zugesetzt werden. Der Mischung können bis zu 5,0 Masse-% des mindestens einen Oxids des Erdalkalimetalls und/oder bis zu 5,0 Masse-% HfO₂ und/oder ZrO₂ zugesetzt werden bzw. eine entsprechende Menge der mindestens einen Verbindung des weiteren Erdalkalimetalls und/oder der Verbindung des Hf und/oder Zr. Ein bevorzugter Bereich für den Zusatz der Oxide und/oder Verbindungen beträgt 0,2 bis 2,0 Masse-%. Durch diese Zusätze wird ein Pinning-Effekt erzielt. Ein Gehalt von bis zu 20,0 Gew.-% eines Erdalkalimetallsulfates wie BaSO₄, SrSO₄ oder deren Mischkristallen, insbesondere von SrSO₄, kann zugegeben werden, insbesondere, um die Gefügeentwicklung von gesinterten oder/und geschmolzenen und abgekühlten Proben zu beeinflussen.

Als Verbindungen des Bi, Pb, Sr, Ca, Cu, Zr, Hf und der weiteren Erdalkalimetalle kommen Oxide, Hydroxide, jede Art anorganischer Salze und metallorganischer Verbindungen wie zum Beispiel Carbonate, Halogenide, Nitrate, Sulfate, Acetate, Alkoholate wie zum Beispiel Isopropanolate, Benzoate, Lactate, Oxalate, Tartrate, Citrate in Frage. Bevorzugte Verbindungen sind Oxide, Hydroxide, Acetate, Alkoholate, Oxalate, Tartrate und Citrate sowie deren Gemische sowie hochschmelzende Sulfate wie Barium- und Strontiumsulfate. Die Verbindungen liegen vorzugsweise in Form einer homogenen, trockenen Mischung vor.

Bevorzugt werden erfindungsgemäß Copräzipitatpulver von Oxalaten oder/und weiteren metallorganischen Verbindungen als Ausgangsmaterial verwendet, die eine besonders homogene Mischung ergeben. Dieses Pulver kann zum Beispiel erhalten werden, indem von einer Nitratlösung der Metalle ausgegangen wird und durch Zugabe von Oxalsäure die Metalloxalate zusammen ausgefällt werden, die dann durch Sprühtrocknung in das Copräzipitatpulver überführt werden.

Als Drehrohrofen wird vorzugsweise ein indirekt beheizter Ofen verwendet, der in seiner Längsneigung verstellt werden kann. Am Rohranfang, von wo aus der Materialeintrag erfolgt, ist eine Absaugeinrichtung vorgesehen. Die Temperatur in der heißesten Zone des Drehrohrofens liegt im Bereich von 650 °C bis 850 °C, besonders bevorzugt von 730 °C bis 780 °C. Die innerhalb dieser Bereiche gewählte Temperatur hängt von anderen Prozeßparametern ab, wie weiter unten näher erläutert wird. Die Verweilzeit der Mischung in der Reaktionszone des Drehrohrofens beträgt mindestens 10 min, bevorzugt 20 bis 40 min. Auch hier richtet sich die jeweils gewählte Verweilzeit nach den anderen Prozeßparametern.

Üblicherweise wird ein zur Umgebung offenes Drehrohr eingesetzt, das mit Luft unter Zugabe von reinem Sauerstoff oder auch jedem anderen beliebigen Gasgemisch mit einem Sauerstoffgehalt von mindestens 10 % betrieben werden kann und dann mit einem Druck etwa von Atmosphärendruck oder nur geringfügig höher zur Erzeugung der Gasströmung betrieben werden kann.

Um Ablagerungen an der Rohrinnenwand und eine Agglomeration der Teilchen besonders zuverlässig zu vermeiden, wird in einer bevorzugten Ausführungsform die zu calcinierende Pulvermischung in eine Zone des Drehrohrofens mit einer Temperatur über 400 °C eingeführt. Dadurch beginnt die Zersetzung der Verbindungen direkt bei der Zugabe, und die entstehenden Gase bilden eine Schicht zwischen dem in diesem Zustand sehr reaktiven Pulver und der Rohrinnenwand.

Um den Materialdurchsatz zu erhöhen, kann das zu calcinierende Material zweimal durch den Drehrohrofen geführt werden. Dabei nimmt man im ersten Durchgang einen etwas erhöhten Restkohlenstoffgehalt in Kauf, hat dafür aber einen um eine Größenordnung höheren Materialdurchsatz, d.h. eine geringere Verweilzeit. Im zweiten Durchgang bei gleichem oder größeren Materialdurchsatz wird der Restkohlenstoffgehalt auf die gewünschten niedrigen Werte herabgesetzt. Eine alternative bevorzugte Ausführungsform zur Erhöhung des Materialdurchsatzes besteht darin, daß die Pulvermischung in einem Luftstrom mit erhöhtem Sauerstoffanteil calciniert wird. Dadurch kann der Materialdurchsatz um den Faktor 1,5 erhöht werden, ohne daß die Eigenschaften des calcinierten Produkts verschlechtert werden und ein zweiter Durchgang erforderlich ist.

Die Eigenschaften des erhaltenen Calcinats, d.h. des Endprodukts des vorliegenden Verfahrens, können durch verschiedene Parameter beeinflußt werden. Da diese Parameter voneinander und auch von der Geometrie des verwendeten Drehrohrofens abhängen, ist die Angabe absoluter Werte für die einzelnen Parameter nicht sinnvoll. Vielmehr wird im folgenden erläutert, wie sich die Eigenschaften des erhaltenen Calcinats ändern, wenn die einzelnen Parameter geändert werden.

Ein wichtiger Parameter ist die Calcinationstemperatur im Drehrohrofen. Wenn diese Temperatur zu niedrig ist, wird der verbleibende Teil an flüchtigen Verunreinigungen, wie zum Beispiel C und N, im Calcinat zu hoch. Wenn die Temperatur zu hoch ist, setzt ein unerwünschtes Kornwachstum durch einen Sinterungsprozeß ein, so daß die Teilchengröße des Calcinats nicht ausreichend klein ist.

Ein weiterer Parameter ist die Neigung des Drehrohrofens. Mit steigender Rohrneigung sinkt die Verweilzeit des Materials in der Reaktionszone. Die thermische Zersetzung des Materials kann unvollständig sein, wenn die Rohrneigung zu groß gewählt wird. Dies gilt insbesondere, wenn eine relativ niedrige Temperatur innerhalb der oben angegebenen Bereiche gewählt wird. Zur Führung des Materialstromes können auch Leitbleche und ähnliche Einbauten vorteilhaft verwendet werden.

Auch die Drehzahl des Rohrofens beeinflußt die Eigenschaften des Calcinats. Grundsätzlich beschleunigt sich der Materialtransport durch den Drehrohrofen, wenn die Rohrdrehzahl erhöht wird. Somit sinkt die Verweilzeit, so daß die obigen Ausführungen zur Rohrneigung hier entsprechend gelten. Bei zu langer Verweilzeit (geringe Rohrneigung und Rohrdrehzahl) kann unerwünschtes Kornwachstum auftreten.

Die pro Zeiteinheit in den Drehrohrofen eingeführte Materialmenge muß ebenfalls mit den anderen Parametern abgestimmt werden. Ist die Materialzugabe bei gegebener Rohrneigung und Rohrdrehzahl zu hoch, bildet sich ein Materialüberschuß am Anfang der Reaktionszone des Drehrohrofens. Die Teilchen agglomerieren und behindern dadurch den weiteren Stofftransport. Dies kann zu Ablagerungen an der Rohrinnenwand führen. Außerdem wird die Verweilzeit zu lang, was zu unerwünschtem Kornwachstum führt. Ferner führt das gelegentliche Abplatzen der Ablagerungen zu nicht reproduzierbaren Eigenschaften des Calcinats.

Die pro Zeiteinheit in den Drehrohrofen eingeführte Materialmenge richtet sich auch nach dem Innendurchmesser des Drehrohrofens. Ein geringes Verhältnis von Materialschütthöhe im Ofen zu seinem Innendurchmesser, zum Beispiel 1:6 bis 1:10, ermöglicht einen niedrigen Restgehalt an Kohlenstoff und Stickstoff im Endprodukt und ist daher vorteilhaft.

Der Materialaustrag aus dem Drehrohrofen ist eine Meßgröße, die durch die zuvor besprochenen Parameter bestimmt wird.

Auch zusätzliche weitere Gehalte an z.B. einer Zr-Verbindung oder an anderen Verbindungen, die 10 Masse-% nicht überschreiten, beeinflussen das erfindungsgemäße Verfahren nicht oder nur geringfügig. Es können auch teilweise thermisch vorzersetzte Mischungen erfindungsgemäß erfolgreich eingesetzt werden. Bei der Verwendung von thermisch vorzersetzten Mischungen oder/und bei mehrfachem Calcinieren, wobei mindestens einer der Öfen ein Drehrohrofen sein sollte, ergeben sich besonders vorteilhafte Eigenschaften, vor allem die geringsten Anteile an Verunreinigungen und höhere Anteile an hochtemperatursupraleitenden Phasen.

Aus den obigen Ausführungen ergibt sich, daß alle Parameter aufeinander abgestimmt werden müssen, um zu einem Calcinat mit geringer Teilchengröße und einem geringen Gehalt an Verunreinigungen zu kommen. Die erläuterten Zusammenhänge zwischen den Parametern und den Produkteigenschaften machen die optimale Einstellung der richtigen Werte für die Parameter möglich.

Das fertige Vorprodukt des erfindungsgemäßen Verfahrens kann je nach den thermischen Behandlungen nur Spuren oder auch bis zu größeren Anteilen an hochtemperatursupraleitenden Phasen enthalten. Meistens liegt die Phase Bi-2212 als hochtemperatursupraleitende Phase vor. Durch eine zusätzliche thermische Behandlung nach dem Calcinieren kann die Phasenzusammensetzung des Materials beeinflußt werden. In Abhängigkeit vom Sauerstoffanteil der Ofenatmosphäre entsteht in Gegenwart von Pb entweder die orthorhombische, Pb-haltige Phase Bi-2212, insbesondere bei weniger als 3 % O₂-Anteil in der Ofenatmosphäre, oder bei einem O₂-Anteil üblicherweise oberhalb von 3 % die tetragonale Pb-freie Phase Bi-2212 zusammen mit Erdalkaliplumbaten und weiteren Sekundärphasen.

Das Vorprodukt des erfindungsgemäßen Verfahrens ist insbesondere auf möglichst geringe Verunreinigungen, homogene Verteilung der Sekundärphasen und feine Korngrößen optimiert, aber auch von Vorteil für die gesamten thermischen Behandlungen, da hierdurch die Reaktionen zu einem Hochtemperatursupraleitermaterial beispielsweise in einem Band, Draht oder Massivteil schneller und leichter abgeschlossen werden können.

### Beispiele

An Hand der folgenden Beispiele wird das erfindungsgemäße Verfahren näher erläutert.

Die in den folgenden Beispielen angegebenen Korngrößen wurden folgendermaßen gemessen. Aus den calcinierten Pulvern wurde ein Preßling hergestellt, keramographisch nach Vakuumimprägnation in ein hierfür gut geeignetes Kunstzharz präpariert und mit Hilfe der automatischen Bildanalyse auflichtmikroskopisch untersucht. Über die Messung des unterschiedlichen Reflexionsvermögens kann die Korngrößenverteilung der Sekundärphasen wie Ca₂CuO₃ und CuO, die heller erscheinen als die anderen Partikel und das Kunstharz, bestimmt werden, deren Verteilung auf dem Bildausschnitt außerdem ein Maß für die Homogenität des Gesamtmaterials darstellt.

In allen Beispielen wurde ein Drehrohrofen mit einer Gesamtrohrlänge von 1,80 m und einer beheizbaren Zone von 0,60 m verwendet. Der Rohrinnendurchmesser betrug 0,12 m. Der Ofen ließ sich in seiner Längsneigung verstellen und hatte eine Absaugeinrichtung am Eingang. Damit entstand ein Gasstrom entgegen der Förderrichtung des Materials. Die Pulvermischung wurde über einen Trichter in eine Rüttelrinne dosiert, deren Ende direkt in der Zone des Drehrohrofens angeordnet wurde, deren Temperatur in den folgenden Beispielen angegeben wird.

### Beispiel 1:

100 g Oxalat auf Basis der Zielzusammensetzung Bi_{1,8}Pb_{0,4}Sr₂Ca_{2,1}Cu₃Oᵥ wurden im Drehrohrofen calciniert, wobei folgende Prozeßparameter gewählt wurden:
Materialeintrag: 3,2 g/min
Temperatur am Ort des Materialeintrags: 430 °C
Calcinationstemperatur: 750 °C
Rohrneigung: 1,2 °
Rohrdrehzahl: 8 U/min
Verweilzeit: ∼ 40 min
Materialaustrag: 1,3 g/min.

Das erhaltene calcinierte Pulver wies einen C-Gehalt von 400 ppm und einen N-Gehalt von 100 ppm auf. Die keramographisch mit Hilfe der Bildanalyse bestimmte Primärteilchenmaximalgröße (5000 untersuchte Teilchen) lag unter 2 µm.

### Beispiel 2:

100 g Oxalat auf Basis der Zielzusammensetzung Bi₂Sr₂CaCu₂Oᵥ wurden im Drehrohrofen calciniert, wobei folgende Prozeßparameter gewählt wurden:
Materialeintrag: 3,2 g/min
Temperatur am Ort des Materialeintrags: 430 °C
Calcinationstemperatur: 750 °C
Rohrneigung: 1,2 °
Rohrdrehzahl: 8 U/min
Verweilzeit: ∼ 40 min
Materialaustrag: 1,3 g/min.

Das erhaltene calcinierte Produkt wies einen C-Gehalt von 500 ppm und einen N-Gehalt von 100 ppm auf. Die keramographisch mit Hilfe der Bildanalyse bestimmte Primärteilchenmaximalgröße lag unter 2 µm.

### Beispiel 3:

100 g Oxalat auf Basis der Zielzusammensetzung Bi_{1,74}Pb_{0,34}Sr_{1,90}Ca_{2,01}Cu₃Oᵥ wurden im Drehrohrofen calciniert, wobei folgende Prozeßparameter gewählt wurden:
Materialeintrag: 3,2 g/min
Temperatur am Ort des Materialeintrags: 430 °C
Calcinationstemperatur: 750 °C
Rohrneigung : 1,6 °
Rohrdrehzahl : 8 U/min
Verweilzeit : ∼ 30 min
Materialaustrag: 1,3 g/min.

Das erhaltene calcinierte Pulver wies einen C-Gehalt von 600 ppm und einen N-Gehalt von 100 ppm auf. Die keramographisch mit Hilfe der Bildanalyse bestimmte Primärteilchenmaximalgröße lag bei 2,31 µm (in 5 Bereichen von 100 x 70 µm gemessen). Die Teilchengrößenverteilung ist in folgender Tabelle wiedergegeben:

| Durchmesser µm | % | Durchmesser µm | % |
|---|---|---|---|
| 0,00 | 0,00 | 5,00 | 0,00 |
| 0,50 | 67,89 | 5,50 | 0,00 |
| 1,00 | 25,37 | 6,00 | 0,00 |
| 1,50 | 5,87 | 6,50 | 0,00 |
| 2,00 | 0,88 | 7,00 | 0,00 |
| 2,50 | 0,00 | 7,50 | 0,00 |
| 3,00 | 0,00 | 8,00 | 0,00 |
| 3,50 | 0,00 | 8,50 | 0,00 |
| 4,00 | 0,00 | 9,00 | 0,00 |
| 4,50 | 0,00 | 9,50 | 0,00. |

### Beispiel 4:

100 g Oxalat auf Basis der Zielzusammensetzung Bi_{1,74}Pb_{0,34}Sr_{1,90}Ca_{2,01}Cu₃Oᵥ wurden im Drehrohrofen calciniert, wobei folgende Prozeßparameter gewählt wurden:
Materialeintrag: 7,0 g/min
Temperatur am Ort des Materialeintrags: 430 °C
Calcinationstemperatur: 750 °C
Rohrneigung: 2 °C
Rohrdrehzahl: 8 U/min
Verweilzeit: ∼ 25 min
Materialaustrag: 3 g/min.

Das erhaltene calcinierte Produkt wies einen C-Gehalt von 1000 ppm und einen N-Gehalt von 200 ppm auf. Die keramographisch mit Hilfe der Bildanalyse bestimmte Primärteilchenmaximalgröße lag unter 2,5 µm.

### Beispiel 5:

In diesem Beispiel wurden zwei Durchgänge durch den Drehrohrofen durchgeführt. 100 g Oxalat auf Basis der Zielzusammensetzung Bi₂Sᵣ₂CaCu₂Oᵥ wurden calciniert, wobei folgende Prozeßparameter für die zwei Druchgänge gewählt wurden:

| | Durchgang 1 | Durchgang 2 |
|---|---|---|
| Materialeintrag: | 35 g/min | 35 g/min |
| Temperatur am Ort des Materialeintrags: | 430 °C | 430 °C |
| Calcinationstemperatur: | 770 °C | 770 °C |
| Rohrneigung: | 1,5 ° | 1,5 ° |
| Rohrdrehzahl: | 8 U/min | 12 U/min |
| Verweilzeit: | ∼ 33 min | ∼ 20 min |
| Materialaustrag: | 15 g/min | 15 g/min. |

Nach dem 2. Durchgang wies das erhaltene calcinierte Pulver einen C-Gehalt von 700 ppm auf. Die keramographisch mit Hilfe der Bildanalyse bestimmte Primärteilchenmaximalgröße lag unter 3,0 µm.

### Beispiel 6:

100 g Oxalat auf Basis der Zielzusammensetzung Bi_{1,74}Pb_{0,34}Sr_{1,90}Ca_{2,01}Cu_{3,05}Oᵥ wurden wie in Beispiel 5 in zwei Durchgängen calciniert. Folgende Prozeßparameter wurden gewählt:

| | Durchgang 1 | Durchgang 2 |
|---|---|---|
| Materialeintrag: | 12 g/min | 25 g/min |
| Temperatur am Ort des Materialeintrags: | 430 °C | 430 °C |
| Calcinationstemperatur: | 750 °C | 750 °C |
| Rohrneigung: | 1,5 ° | 1,5 ° |
| Rohrdrehzahl: | 8 U/min | 8 U/min |
| Verweilzeit: | ∼ 33 min | ∼ 33 min |
| Materialaustrag: | 5 g/min | 10 g/min. |

Nach dem 2. Durchgang wies das erhaltene calcinierte Pulver einen C-Gehalt von 600 ppm und einen N-Gehalt von 100 ppm auf. Die keramographisch mit Hilfe der Bildanalyse bestimmte Primärteilchenmaximalgröße lag unter 3,0 µm.

### Beispiel 7:

100 g Oxalat auf Basis der Zielzusammensetzung Bi_{1,8}Pb_{0,4}Sr₂Ca_{2,1}Cu₃Oᵥ wurden wie in Beispiel 5 in zwei Durchgängen calciniert. Folgende Prozeßparameter wurden gewählt:

| | Durchgang 1 | Durchgang 2 |
|---|---|---|
| Materialeintrag: | 12,0 g/min | 12,0 g/min |
| Temperatur am Ort des Materialeintrags: | 430 °C | 430 °C |
| Calcinationstemperatur: | 750 °C | 750 °C |
| Rohrneigung: | 1,2 ° | 1,5 ° |
| Rohrdrehzahl: | 8 U/min | 8 U/min |
| Verweilzeit: | ∼ 40 min | ∼ 33 min |
| Materialaustrag: | 5 g/min | 5 g/min. |

Nach dem 2. Durchgang wies das erhaltene calcinierte Pulver einen C-Gehalt von 400 ppm und einen N-Gehalt von 100 ppm auf. Die keramographisch mit Hilfe der Bildanalyse bestimmte Primärteilchenmaximalgröße lag unter 2,5 µm.

### Beispiel 8:

500 g Oxalat auf Basis der Zielzusammensetzung Bi_{1,8}Pb_{0,4}Sr₂Ca_{2,1}Cu₃Oᵥ wurden im Drehrohrofen calciniert, wobei 200 l Sauerstoff pro Stunde im Gegenstrom in den Ofen eingeblasen wurden. Folgende Prozeßparameter wurden gewählt:
Materialeintrag: 5 g/min
Temperatur am Ort des Materialeintrags: 430 °C
Calcinationstemperatur: 750 °C
Rohrneigung: 1,2 °
Rohrdrehzahl: 6 U/min
Verweilzeit: ∼ 45 min
Materialaustrag: 2 g/min.

Das erhaltene calcinierte Pulver wies einen C-Gehalt von 450 ppm und einen N-Gehalt von 100 ppm auf. Die keramographisch mit Hilfe der Bildanalyse bestimmte Primärteilchenmaximalgröße lag unter 2,5 µm.

### Beispiel 9:

100 g eines Gemisches aus Zitraten von Cu, Bi, Pb und Hydraten von Sr und Ca auf Basis der Zielzusammensetzung Bi_{1,74}Pb_{0,34}Sr_{1,90}Ca_{2,01}Cu₃Oᵥ wurden im Drehrohrofen calciniert, wobei folgende Prozeßparameter gewählt wurden:
Materialeintrag: 7,0 g/min
Temperatur am Ort des Materialeintrags: 400 °C
Calcinationstemperatur: 730 °C
Rohrneigung: 2 °C
Rohrdrehzahl: 8 U/min
Verweilzeit: ∼ 25 min
Materialaustrag: 4 g/min.

Das erhaltene calcinierte Produkt wies einen C-Gehalt von 300 ppm und einen N-Gehalt unterhalb der Nachweisgrenze von 50 ppm auf. Die keramographisch mit Hilfe der Bildanalyse bestimmte Primärteilchenmaximalgröße lag unter 2,0 µm.

### Vergleichsbeispiel:

1000 g Oxalat auf Basis der Zielzusammensetzung Bi_{1,74}Pb_{0,34}Sr_{1,90}Ca_{2,01}Cu_{3,05}Oᵥ wurden in zwei Al₂0₃-Tiegel mit je 500 g aufgeteilt. In einem konventionellen Rohrofen wurde das Material in den zwei Tiegeln zuerst 10 h bei 700 °C unter ruhender Luft, dann 20 h bei 800 °C im Sauerstoffstrom und dann 5 h bei 790 °C im Luftstrom thermisch behandelt. Zwischen den Glühschritten erfolgte eine Absiebung mit einem 40 µm-Sieb. Das erhaltene calcinierte Pulver wies einen C-Gehalt von 500 ppm und einen N-Gehalt von 100 ppm auf. Die keramographisch mit Hilfe der Bildanalyse bestimmte Primärteilchenmaximalgröße lag bei Werten bis dicht unter 8,5 µm; die Homogenität der Verteilung der Sekundärphasen im Preßling war bei der visuellen Untersuchung deutlich schlechter als bei allen erfindungsgemäßen Beispielen.

## Patentansprüche

1. Verfahren zur Herstellung von hochtemperatursupraleitenden Bi(Pb)SrCaCu0-haltigen Pulvern, dadurch gekennzeichnet, daß eine Pulvermischung, die Verbindungen des Bi, Sr, Ca, Cu sowie wahlweise Pb enthält, die sich beim Calcinieren in die jeweiligen Oxide und/oder Mischoxide umwandeln, in einem Drehrohrofen kontinuierlich calciniert wird.

2. Verfahren nach Anspruch 1, dadurch gekennzeichnet, daß die Pulvermischung die Verbindungen des Bi, Sr, Ca, Cu und wahlweise Pb in solchen Mengenverhältnissen enthält, daß sie zu einem Pulver der Zusammensetzung Bi_{a-y}Pb_{y}(Sr,Ca)_{b+n}Cu_{c+n}0ₓ calciniert wird, wobei
a = 1,7 bis 2,4
y = 0 bis 0,5
b = 1,6 bis 3,0
c = 1,8 bis 2,2
n = 1,2 und
x = 5,95 bis 11,5
beträgt .

3. Verfahren nach Anspruch 1, dadurch gekennzeichnet, daß die Pulvermischung die Verbindungen des Bi, Sr, Ca und Cu in solchen Mengenverhältnissen enthält, daß sie zu einem Pulver der Zusammensetzung Bi_{d}SrₑCa_{f}Cu_{g}O_{z} calciniert wird, wobei
d = 1,6 bis 2,3
e = 1,7 bis 2,4
f = 0,7 bis 1,2
g = 1,7 bis 2,3 und
z = 8,0 bis 10,0
beträgt.

4. Verfahren nach einem der Ansprüche 1 bis 3, dadurch gekennzeichnet, daß die Pulvermischung außerdem mindestens eine Verbindung eines weiteren Erdalkalimetalls, die sich beim Calcinieren in das Oxid umwandelt, oder mindestens ein Oxid eines weiteren Erdalkalimetalls enthält oder/und ein Erdalkalisulfat wie z. B. Sr SO₄.

5. Verfahren nach einem der Ansprüche 1 bis 4, dadurch gekennzeichnet, daß die Pulvermischung außerdem eine Verbindung des Hf und/oder Zr, die sich beim Calcinieren in das Oxid umwandelt, oder HfO₂ und/oder ZrO₂ enthält.

6. Verfahren nach Anspruch 4 oder 5, dadurch gekennzeichnet, daß die Pulvermischung bis zu 5,0 Masse-% des mindestens einen Oxids des Erdalkalimetalls und/oder bis zu 5,0 Masse-% HfO₂ und/oder ZrO₂ oder eine entsprechende Menge der mindestens einen Verbindung des weiteren Erdalkalimetalls und/oder der Verbindung des Hf und/oder Zr enthält.

7. Verfahren nach einem der Ansprüche 1 bis 6, dadurch gekennzeichnet, daß als Pulvermischung ein Copräzipitat, insbesondere von Acetaten, Alkoholaten, Carbonaten, Citraten, Hydroxiden, Oxalaten, Tartraten oder und deren Gemischen verwendet wird.

8. Verfahren nach einem der Ansprüche 1 bis 7, dadurch gekennzeichnet, daß die Calcinationstemperatur im Drehrohrofen 650°C bis 850°C beträgt.

9. Verfahren nach Anspruch 8, dadurch gekennzeichnet, daß die Calcinationstemperatur 730°C bis 780°C beträgt.

10. Verfahren nach einem der Ansprüche 1 bis 9, dadurch gekennzeichnet, daß die Pulvermischung in eine Zone des Drehrohrofens eingeführt wird, in der die Temperatur über 400°C beträgt.

11. Verfahren nach einem der Ansprüche 1 bis 10, dadurch gekennzeichnet, daß die Verweilzeit der Pulvermischung in der Reaktionszone mindestens 10 min beträgt.

12. Verfahren nach einem der Ansprüche 1 bis 11, dadurch gekennzeichnet, daß die Pulvermischung im Drehrohrofen in einem Sauerstoffgegenstrom calciniert wird.

13. Verfahren nach einem der Ansprüche 1 bis 12, dadurch gekennzeichnet, daß die Pulvermischung nach der Calcination noch mindestens einer Mahlung oder/und mindestens einer Glühung zum Erzeugen eines noch höheren Anteils an hochtemperatursupraleitenden Phasen unterworfen wird.

14. Verwendung des nach einem der Ansprüche 1 bis 13 hergestellten Pulvers als Vorprodukt für die Herstellung von hochtemperatursupraleitenden Drähten, Bändern, Stäben, Rohren, Hohl- und Vollkörpern, insbesondere zur Herstellung von Starkstromkabeln, Transformatoren, Wicklungen, Magneten oder Stromzuführungen.
